# FASCICULE DE BREVET EUROPEEN

(11) **EP 0 367 688 B1**
(45) Date de publication et mention de la délivrance du brevet: **02.03.1994**
(21) Numéro de dépôt: 89420412.2
(22) Date de dépôt: 25.10.1989
(51) Int. Cl.: G01R 31/08

(54) **Procédé et dispositif de détection de coupure de la ligne de transmission d'un automate de gestion technique de bâtiment**
Verfahren und Anordnung zur Ermittlung einer Unterbrechung in einer Übertragungsverbindung
Process and appliance for detecting an open circuit in a transmission line

(30) Priorité: 04.11.1988 FR 8815054
(43) Date de publication de la demande: 09.05.1990
(73) Titulaire: MERLIN GERIN, F-38240 Meylan (FR)
(72) Inventeur: Lhuillier, Henri, F-38050 Grenoble Cedex (FR); Chevaleyre, Robert, F-38050 Grenoble Cedex (FR); Moutet, Serge, F-38050 Grenoble Cedex (FR)
(74) Mandataire: Jouvray, Marie-Andrée

(56) Documents cités:
- EP-A- 0 163 921
- GB-A- 2 008 362
- GB-A- 2 123 589

## Description

L'invention est relative à un procédé de détection d'interruption d'une ligne à deux fils de transmission de données reliant plusieurs modules associés à des capteurs et/ou actionneurs d'un automate de gestion technique de bâtiment pour la transmission de messages asynchrone entre les modules et/ou avec une unité centrale, chaque module étant téléalimenté par ladite ligne et la modulation étant réalisée par mise en court-circuit de la ligne.

La demande de brevet français n° 8815053 déposée le 04.11.1988 (= EP-A-0 370 921), décrit un automate de gestion technique de bâtiment répondant au besoin d'automatisation des immeubles, et susceptible d'être adapté aisément à différentes structures. L'émission de messages par les différents modules reliés par le réseau ou la ligne bifilaire est obtenue par pincement ou mise en court-circuit de la ligne, pour créer une modulation à deux niveaux de tension. Le niveau de tension élevé permet l'alimentation des modules par la ligne à deux fils, ce qui simplifie notablement l'installation de l'automate. L'une des conditions essentielles des automatismes et de leur bon fonctionnement, est la signalisation de toute défaillance, de préférence avant que cette défaillance puisse affecter le bon fonctionnement de l'installation.

La présente invention a pour but de permettre une détection d'interruption de la ligne à deux fils tout en conservant la continuité du service.

Il existe divers procédés de détection d'une coupure d'un bus de transmission de données en forme de boucle. Le document EP-A-163.921, notamment, décrit une installation de traitement de données de mesure comportant un bus de transmission bouclé sur une unité centrale qui analyse, en parallèle ou séquentiellement, les signaux reçus sur les deux extrémités du bus. Dans le document GB-A-2.008.362, une ligne de transmission en forme de boucle connecte un ordinateur central à des terminaux et la détection d'une coupure est réalisée par détection de porteuse. Aucun de ces procédés n'est adapté à la détection de coupure dans un automate de gestion du type décrit dans la dermande de brevet français précité.

Selon l'invention un procédé de détection d'interruption d'une ligne de transmission de données reliant plusieurs modules à une unité centrale qui comporte des bornes de départ et des bornes d'arrivée de ladite ligne et des moyens de comparaison pouvant être connectés sélectivement aux bornes de départ ou aux bornes d'arrivée, est caractérisé en ce que les modules sont associés à des capteurs et/ou actionneurs d'un automate de gestion technique de bâtiment pour la transmission de messages asynchrone entre les modules et/ou avec l'unité centrale, chaque module étant téléalimenté par ladite ligne, à deux fils, et la modulation étant réalisée par mise en court-circuit de la ligne. En fonctionnement normal le départ et l'arrivée de la ligne sont connectés dans l'unité centrale au moyen d'un interrupteur, l'unité centrale comportant un émetteur et un premier récepteur de message reliés en permanence au départ de la ligne, un second récepteur relié à l'arrivée et les moyens de comparaison comportant un comparateur comparant en fonctionnement normal les signaux émis par l'émetteur et reçus par le premier récepteur, le procédé consistant lors d'une opération de détection de coupure, à déconnecter l'arrivée du départ, à déconnecter le récepteur au départ du comparateur et à connecter le comparateur au second récepteur pour comparer les signaux émis sur le départ de la ligne aux signaux reçus à l'arrivée de la ligne et détecter toute discordance.

En rebouclant la ligne sur elle-même du côté de l'unité centrale qui commande le fonctionnement de l'automate, les signaux sont envoyés par les deux extrémités sur la ligne et une interruption de cette dernière en un point quelconque n'affecte pas l'acheminement des messages le long de la ligne à deux fils. La continuité de service est de ce fait assurée, mais on n'est pas à l'abri d'une deuxième défaillance, notamment d'une deuxième interruption de la ligne, qui bien entendu isolerait les modules intercalés entre les deux coupures. En déclenchant périodiquement une procédure de détection d'une coupure, cette dernière est signalée généralement avant l'apparition d'une deuxième coupure, en permettant une réparation avant la défaillance de l'automate. L'unité centrale ainsi que les modules reliés à la ligne bifilaire sont dotés chacun d'un émetteur et d'un récepteur, ce dernier écoutant en permanence la ligne, d'une part pour empêcher toute émission tant que la ligne n'est pas libre, et d'autre part pour déclencher lors d'une émission simultanée à deux modules, une procédure de retrait de l'émetteur non prioritaire. A cet effet un comparateur ou détecteur de collision reçoit, d'une part les signaux reçus par l'unité centrale, et d'autre part les signaux émis par cette unité. Il est inutile de décrire plus en détail un tel automate de gestion technique de bâtiment, le lecteur pouvant se reporter à la demande de brevet citée ci-dessus pour de plus amples détails.

Selon la présente invention, la ligne à deux fils est rebouclée sur l'unité centrale et le départ et l'arrivée de la ligne sont normalement connectés en parallèle par l'intermédiaire d'un interrupteur avantageusement du type électronique, ce qui permet l'émission des signaux par les deux extrémités de la ligne. A intervalle régulier, l'unité centrale ouvre l'interrupteur de connexion des deux extrémités de la ligne, laquelle émet un signal de vérification sur les bornes de départ de la ligne. En cas de continuité de la ligne à deux fils, ce signal apparaît sur les bornes d'arrivée de l'unité centrale et est transmis par l'intermédiaire d'un récepteur et d'une liaison opto-électronique au comparateur. Ce comparateur vérifie l'identité des signaux émis sur le départ de la ligne et des signaux reçus sur l'arrivée de la ligne, et en cas de non-réception de signaux sur l'arrivée lors d'une émission d'un signal sur le départ, signale la défaillance généralement constituée par l'interruption d'un ou des deux fils de la ligne. Cette procédure de contrôle est intercalée dans le cycle normal de fonctionnement de l'automate qui n'est pas perturbé. Le message ou les signaux de contrôle peuvent présenter un formatage approprié, mais on ne sortirait pas du cadre de l'invention, en réalisant l'opération de contrôle lors de la transmission d'un message standard par l'unité centrale.

Selon un développement de l'invention, la détection ou la localisation de la coupure de la ligne peut être facilitée par une interrogation successive des différents modules, et par l'écoute des réponses de ces derniers. Une non-réponse de l'un des modules confirme la non-réception du message due à la coupure de la ligne en amont de ce module.

L'invention est également relative à un dispositif de détection de coupure d'une ligne de transmission de données binaires entre des modules et une unité centrale qui comporte des bornes de départ connectées au départ de la ligne et des bornes d'arrivée connectées à l'arrivée de la ligne, et des moyens de comparaison pouvant être connectés sélectivement aux bornes de départ ou aux bornes d'arrivée, dispositif caractérisé en ce que les modules sont associés à des capteurs et/ou actionneurs d'un automate de gestion technique de bâtiment pour la transmission de messages asynchrone entre les modules et/ou l'unité centrale, chaque module étant alimenté en énergie par le niveau haut de la tension de la ligne, à deux fils, modulée à deux niveaux de tension par la mise en/et hors court-circuit par l'un des modules en émission,l'unité centrale comportant un interrupteur de connexion desdites bornes de départ et d'arrivée en fonctionnement normal et de déconnexion en phase de détection de coupure, un premier récepteur et un émetteur reliés aux bornes de départ et un second récepteur relié aux bornes d'arrivée , les moyens de comparaison comportant un comparateur comparant en fonctionnement normal les signaux reçus par le premier récepteur avec les signaux émis sur ledit départ, un dispositif d'inhibition déconnectant le comparateur du récepteur relié au départ pendant la phase de détection de coupure. Dans l'unité centrale, les deux paires de bornes sont reliées par un interrupteur normalement fermé, permettant une alimentation et une mise en parallèle des deux extrémités de la ligne. L'unité centrale comporte un bloc d'alimentation constitué par un générateur de tension limité en courant pour permettre de la manière décrite dans la demande de brevet précitée, une émission par mise en court-circuit ou pincement de la ligne, par un émetteur de l'un quelconque des modules. La ligne ou le réseau est à deux fils, et de ce fait ne pose pas de problèmes particuliers pour un rebouclage sur l'unité centrale. Le dispositif de détection de coupure fait usage des constituants usuels des modules, notamment de l'unité centrale à laquelle il suffit d'incorporer un dispositif interrupteur et un récepteur additionnel. Ces modifications sont particulièrement simples et assurent une sécurité de fonctionnement largement suffisante pour ce type d'automate.

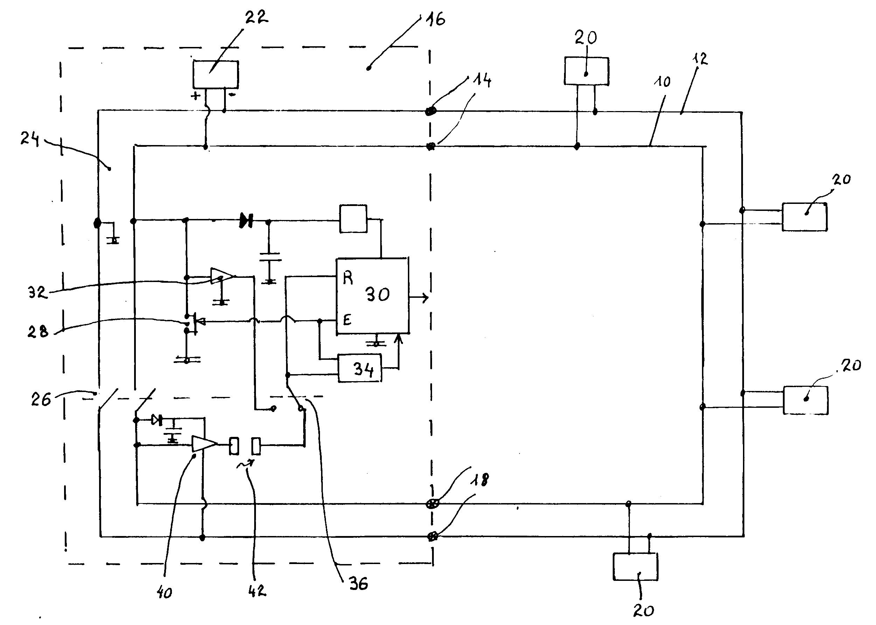

D'autres avantages et caractéristiques ressortiront plus clairement de la description qui va suivre, d'un mode de mise en oeuvre de l'invention donné à titre d'exemple non limitatif et représenté au dessin annexé dont la figure unique montre le schéma bloc d'un automate de gestion technique de bâtiment, équipé d'un dispositif de détection de coupure de la ligne selon l'invention.

Sur la figure une ligne à deux fils 10,12 est connectée du côté du départ à une paire de bornes 14 d'une unité centrale 16. Les extrémités opposées de la ligne à deux fils 10,12 sont reliées à une deuxième paire de bornes 18 d'arrivée de l'unité centrale 16. Le long de la ligne à deux fils 10,12 sont échelonnés des modules 20 qui sont, soit des modules de capteur, soit des modules d'actionneurs disséminés dans le bâtiment pour en assurer la gestion technique. Chaque module 20 comporte un dispositif de réception et un dispositif émetteur permettant de recevoir des données binaires transmises par la ligne à deux fils 10,12 et d'émettre sur cette dernière des informations. Les différents modules 20 sont alimentés en énergie par un bloc d'alimentation 22 appartenant à l'unité centrale 16. Les deux paires de bornes 14,18 sont reliées dans l'unité centrale 16 par une boucle 24 dans laquelle est inséré un interrupteur 26, de préférence électronique permettant d'interrompre la connexion. En position fermé de l'interrupteur 26, le bloc d'alimentation 22 alimente par ces deux extrémités la ligne à deux fils 10,12, ce qui permet une réduction de la résistance électrique apparente de la ligne. L'unité centrale comporte un dispositif d'émission et de réception connecté en parallèle au bloc d'alimentation 22, et susceptible d'émettre et de recevoir les messages transmis sur la ligne à deux fils 10,12. Le dispositif d'émission comporte un contact 28 de mise en court-circuit de la ligne à deux fils 10,12 lors de sa fermeture, pour provoquer une chute de tension correspondant à un niveau de tension bas représentatif d'un bit à zéro du signal. L'ouverture de l'interrupteur 28 correspond à un niveau élevé, en l'occurrence à un bit à niveau 1 qui assure l'alimentation en énergie des modules 20 raccordés à la ligne à deux fils 10,12. L'émission est pilotée par un microprocesseur 30 qui reçoit sur le port de réception "R", les signaux transmis par la ligne à deux fils 10,12, par l'intermédiaire d'un amplificateur 32. Le port de réception "R" et le port d'émission "E" du microprocesseur 30 sont tous deux reliés à un comparateur 34 qui transmet au microprocesseur 30 une information de non-concordance des signaux émis et reçus. Le port de réception "R" et le comparateur 34 sont raccordés à un commutateur 36, solidaire de l'interrupteur 26 et s'ouvrant avec ce dernier pour interrompre la transmission au comparateur et au microprocesseur des signaux reçus par l'amplificateur 32 pendant la phase de détection d'interruption, correspondant à l'ouverture de l'interrupteur 26 et se brancher à un récepteur 40. Le récepteur 40 est relié aux bornes d'arrivée 18 et les signaux reçus sont transmis par une liaison opto-électronique 42 au commutateur 36.

Le dispositif de détection d'interruption fonctionne de la manière suivante:

En fonctionnement normal l'interrupteur 26 est fermé, et le contact 36 raccorde l'amplificateur 32 au port de réception "R". L'automate fonctionne normalement, l'alimentation par le bloc 22 et les signaux émis par l'unité centrale étant transmis à la fois par le départ et l'arrivée de la ligne à deux fils. Cette alimentation et transmission par les deux extrémités ne modifie pas le fonctionnement, mais bien au contraire permet une réduction des pertes dans la ligne à deux fils. A intervalles réguliers, le microprocesseur 30 provoque une procédure de détection de coupure de la ligne, par ouverture de l'interrupteur 26 et émission d un message de contrôle, par ouverture et fermeture des contacts 28 d'émission. Simultanément à l'ouverture de l'interrupteur 26 isolant les bornes d'arrivée 18 des bornes d'entrée 14, le commutateur 36 bascule pour aiguiller la réception venant du récepteur 40 vers le port de réception du microprocesseur 30. La transmission de ces signaux est assurée par la liaison opto-électronique 42 au port de réception du microprocesseur 30 et au bloc comparateur 34, qui vérifie la concordance entre les signaux émis sur les bornes de départ 14, et les signaux reçus sur les bornes d'arrivée 18. La non-réception des signaux sur les bornes d'arrivée 18, correspond à une interruption ou une coupure de la ligne, en l'occurrence de l'un ou des deux fils 10,12. Lors d'une concordance des signaux, la continuité de la ligne est confirmée et le dispositif revient dans la position originale de fonctionnement normal. La procédure de contrôle est relativement courte et elle s'intercale dans le fonctionnement normal de l'automate qui n'est pas perturbé. La fréquence de contrôle dépend bien entendu de la qualité du contrôle, et des risques de coupure du réseau ou de la ligne à deux fils 10,12.

Lors d'une détection d'une coupure de la ligne à deux fils 10,12, il peut être utile de localiser le défaut et selon un perfectionnement de l'invention, cette localisation est réalisée par une émission de messages par l'unité centrale 16 aux différents modules 20. Ceux-ci sont interrogés et doivent répondre, et l'ordre d'interrogation et de réponse, correspond de préférence à l'échelonnement des modules 20 le long de la ligne à deux fils 10,12. L'absence de réponse correspond à la non-réception du message, c'est à dire à la coupure de la ligne en amont du module n'ayant pas répondu. Cette procédure d'interrogation peut être réalisée pendant l'ouverture de l'interrupteur 26, pour éviter toute interférence entre les signaux transmis sur l'entrée et sur la sortie de l'unité centrale 16.

Le procédé et le dispositif de détection de coupure de la ligne à deux fils sont particulièrement simples et appropriés à un automate de gestion technique de bâtiment, dont la structure n'est pratiquement pas modifiée.

## Revendications

1. Procédé de détection d'interruption d'une ligne (10,12) de transmission de données reliant plusieurs modules (20) à une unité centrale (16) qui comporte des bornes de départ (14) et des bornes d'arrivée (18) de ladite ligne et des moyens de comparaison (34) pouvant être connectés sélectivement aux bornes de départ (14) ou aux bornes d'arrivée (18), procédé caractérisé en ce que les modules (20) sont associés à des capteurs et/ou actionneurs d'un automate de gestion technique de bâtiment pour la transmission de messages asynchrone entre les modules et/ou avec l'unité centrale (16), chaque module (20) étant téléalimenté par ladite ligne, à deux fils, et une modulation à deux niveaux de tension étant réalisée par mise en court-circuit de la ligne, procédé selon lequel, en fonctionnement normal le départ et l'arrivée de la ligne (10, 12) sont connectes ensemble dans l'unité centrale au moyen d'un interrupteur (26), l'unité centrale (16) comportant un émetteur (28) et un premier récepteur (32) de message reliés en permanence au départ (14) de la ligne, un second récepteur (40) relié à l'arrivée et les moyens de comparaison comportant un comparateur (34) comparant en fonctionnement normal les signaux émis par l'émetteur (28) et reçus par le premier récepteur (32), le procédé consistant lors d'une opération de détection de coupure, à déconnecter l'arrivée (18) du départ (14), à déconnecter le premier récepteur (32) relié au départ du comparateur (34) et à connecter le comparateur (34) au second récepteur (40) pour comparer les signaux émis sur le départ de la ligne aux signaux reçus à l'arrivée de la ligne et détecter toute discordance.

2. Procédé selon la revendication 1, caractérisé en ce que l'émetteur (28) relié au départ (14) émet un message particulier de détection de coupure de la ligne à intervalle régulier, la continuité de service étant assurée.

3. Procédé selon la revendication 1 ou 2, caractérisé en ce que lors d'une détection de coupure de la ligne (10,12), l'émetteur (28) relié au départ de la ligne interroge successivement les modules (20) reliés à la ligne à deux fils pour localiser l'endroit de la coupure lors d'une non-réponse de l'un des modules.

4. Dispositif de détection de coupure d'une ligne de transmission (10,12) de données binaires entre des modules (20) et une unité centrale (16) qui comporte des bornes de départ connectées au départ (14) de la ligne, des bornes d'arrivée connectées à l'arrivée (18) de la ligne, et des moyens de comparaison (34) pouvant être connectés sélectivement aux bornes de départ ou aux bornes d'arrivée, dispositif caractérisé en ce que les modules sont associés à des capteurs et/ou actionneurs d'un automate de gestion technique de bâtiment pour la transmission de messages asynchrone entre les modules et/ou l'unité centrale, chaque module (20) étant alimenté en énergie par le niveau haut de la tension de la ligne, à deux fils, modulée à deux niveaux de tension par la mise en/et hors court-circuit par l'un des modules en émission,l'unité centrale (16) comportant un interrupteur (26) de connexion desdites bornes de départ et d'arrivée (14, 18) en fonctionnement normal et de déconnexion en phase de détection de coupure, un premier récepteur (32) et un émetteur (28) reliés aux bornes de départ (14) et un second récepteur (40) relié aux bornes d'arrivée (18), les moyens de comparaison comportant un comparateur (34) comparant en fonctionnement normal les signaux reçus par le premier récepteur (32) avec les signaux émis sur ledit départ, un dispositif d'inhibition (36) déconnectant le comparateur (34) du premier récepteur (32) relié au départ (14) pendant la phase de détection de coupure et connectant le second récepteur (40) audit comparateur, de manière à permettre une comparaison des signaux émis sur ledit départ et des signaux reçus sur ladite arrivée.

5. Dispositif selon la revendication 4, caractérisé en ce que après une détection de coupure, l'unité centrale (16) déclenche un cycle de localisation de la coupure par des interrogations successives, dans l'ordre de connexion à la ligne, des différents modules (20).

## Claims

1. A process for detecting a break in a data transmission line (10, 12) connecting several modules (20) to a central unit (16) comprising output terminals (14) and input terminals (18) of said line and comparison means (34) able to be connected selectively to the output terminals (14) or to the input terminals (18), a process characterized in that the modules (20) are associated with sensors and/or actuators of a technical building management controller for asynchronous transmission of messages between the modules and/or with the central unit (16), each module (20) being remotely supplied with power by said two-wire line, and modulation with two voltage levels being performed by short-circuiting the line, a process whereby, in normal operation the output and input of the line (10, 12) are connected together in the central unit by means of a switch (26), the central unit (16) comprising a message transmitter (28) and a first message receiver (32) continuously connected to the line output (14), a second receiver (40) connected to the input and the comparison means comprising a comparator (34) comparing in normal operation the signals emitted by the transmitter (28) and received by the first receiver (32), the process consisting when a break detection operation is performed, in disconnecting the input (18) from the output (14), in disconnecting the first receiver (32) connected to the output of the comparator (34) and in connecting the comparator (34) to the second receiver (40) to compare the signals transmitted on the line output with the signals received on the line input and in detecting any disagreement.

2. The process according to claim 1, characterized in that the transmitter (28) connected to the output (14) emits a particular line break detection message at regular intervals, continuity of service being ensured.

3. The process according to claim 1 or 2, characterized in that when a break in the line (10, 12) is detected, the transmitter (28) connected to the line output successively addresses enquiries to the modules (20) connected to the two-wire line to locate the location of the break when one of the modules fails to respond.

4. A device for detecting a break in a binary data transmission line (10, 12) between modules (20) and a central unit (16) comprising output terminals connected to the line output (14), input terminals connected to the line input (18), and comparison means (34) able to be connected selectively to the output terminals or to the input terminals, a device characterized in that the modules are associated with sensors and/or actuators of a technical building management controller for asynchronous transmission of messages between the modules and/or the central unit, each module (20) being supplied with power by the high level of the two-wire line voltage, modulated on two voltage levels by short-circuiting and switching out of short-circuit by one of the modules on emission, the central unit (16) comprising a switch (26) for connection of said output and input terminals (14, 18) in normal operation and for disconnection in the break detection phase, a first receiver (32) and transmitter (28) connected to the output terminals (14) and a second receiver (40) connected to the input terminals (18), the comparison means comprising a comparator (34) comparing in normal operation the signals received by the first receiver (32) with the signals emitted on said output, a disabling device (36) disconnecting the comparator (34) from the first receiver (32) connected to the output (14) during the break detection phase and connecting the second receiver (40) to sad comparator, In such a way as to enable comparison of the signals emitted on said output with the signals received on said input.

5. The device according to claim 4, characterized in that after a break has been detected, the central unit (16) triggers a break location cycle by successive enquiries to the different modules (20), in the order of connection to the line.

## Patentansprüche

1. Verfahren zur Bruchüberwachung einer Datenübertragungsleitung (10, 12), die mehrere Module (20) mit einer Zentraleinheit (16) verbindet, die über Abgangsklemmen (14) und Eingangsklemmen (18) der genannten Leitung sowie über wahlweise an die Abgangsklemmen (14) oder die Eingangsklemmen (18) anschließbare Vergleichsmittel (34) verfügt, dadurch gekennzeichnet, daß die Module (20) Meßwertgebern und/oder Stellgliedern einer Gebäudesystemtechnik-Steuerung zur asynchronen Übertragung von Signalen zwischen den einzelnen Modulen oder zwischen den Modulen und der Zentraleinheit (16) zugeordnet sind, wobei jedes Modul (20) über die genannte Zweidrahtleitung versorgt wird und eine Modulation auf zwei Spannungspegel durch Kurzschließen der Leitung erfolgt, daß im Normalbetrieb die Abgangs- und Eingangspunkte der Leitung (10, 12) über einen Schalter (26) in der Zentraleinheit (16) miteinander verbunden sind, wobei die Zentraleinheit (16) einen Signalgeber (28) und eine erste Empfangsschaltung (32), die ständig mit dem Leitungsabgang (14) verbunden sind, sowie eine zweite Empfangsschaltung (40) aufweist, die mit dem Eingang und den Vergleichsmitteln verbunden ist, die Vergleichsmittel einen Komparator (34) umfassen, der im Normalbetrieb die vom Signalgeber (28) ausgesandten mit den von der ersten Empfangsschaltung (32) empfangenen Signalen vergleicht, und das Verfahren bei der Überprüfung auf Leitungsbruch so arbeitet, daß die Verbindung zwischen Leitungseingang (18) und Leitungsabgang (14) unterbrochen, die erste Emptangsschaltung (32) vom Komparator (34) getrennt, und der Komparator (34) mit der zweiten Empfangsschaltung (40) verbunden wird, um die auf den Leitungsabgang gegebenen Signale mit den am Leistungseingang empfangenen Signalen zu vergleichen und jegliche Abweichung festzustellen.

2. Verfahren nach Anspruch 1, dadurch gekennzeichnet, daß der mit dem Abgang (14) verbundene Signalgeber (28) in regelmäßigen Zeitabständen ein besonderes Signal zur Bruchüberprüfung der Leitung aussendet, wobei die Betriebskontinuität aufrechterhalten bleibt.

3. Verfahren nach Anspruch 1 oder 2, dadurch gekennzeichnet, daß der mit dem Leitungsabgang verbundene Signalgeber (28) bei Bruchüberprüfung der Leitung (10, 12) die an die Zweidrahtleitung angeschlossenen Module (20) nacheinander abfragt, um bei Ausbleiben eines Antwortsignals durch eines der Module die Stelle des Leitungsbruchs zu lokalisieren.

4. Anordnung zur Bruchüberwachung einer Leitung (10, 12) zur Übertragung binärer Daten zwischen mehreren Modulen (20) und einer Zentraleinheit (16), die mit dem Leitungsabgang (14) verbundene Abgangsklemmen und mit dem Leitungseingang (18) verbundene Eingangsklemmen sowie wahlweise an die Abgangs- oder Eingangsklemmen anschließbare Vergleichsmittel (34) aufweist, dadurch gekennzeichnet, daß die Module Meßwertgebern und/oder Stellgliedern einer Gebäudesystemtechnik-Steuerung zur asynchronen Übertragung von Signalen zwischen den einzelnen Modulen oder zwischen den Modulen und der Zentraleinheit zugeordnet sind, jedes Modul (20) über die genannte Zweidrahtleitung durch den hohen Spannungspegel gespeist wird, die Modulation der Leitung auf zwei Spannungspegel durch Trennen bzw. Kurzschließen durch eines der aussendenden Module erfolgt, die Zentraleinheit (16) einen Schalter (26) zur Verbindung der genannten Abgangs- und Eingangsklemmen (14, 18) im Normalbetrieb und zu ihrer Trennung während der LeitungsbruchÜberprüfüngsphase, eine erste Empfangsschaltung (32) und einen Signalgeber (28), die an die Abgangsklemmen (14) angeschlossen sind, sowie eine zweite, an die Eingangsklemmen (18) angeschlossene Empfangsschaltung (40) aufweist und die Vergleichsmittel einen Komparator (34) umfassen, der im Normalbetrieb die von der ersten Empfangsschaltung (32) empfangenen mit den über den genannten Abgang ausgesandten Signalen vergleicht, wobei eine Unterdrückungsschaltung (36) den Komparator (34) während der Leitungsbruch-Überprüfungsphase von der am Abgang (14) angeschlossenen ersten Empfangsschaltung (32) trennt und die zweite Empfangsschaltung (40) mit dem genannten Komparator verbindet, so daß die über den genannten Abgang ausgesandten mit den am genannten Eingang empfangenen Signalen verglichen werden können.

5. Anordnung nach Anspruch 4, dadurch gekennzeichnet, daß nach Erfassung eines Leitungsbruchs die Zentraleinheit (16) einen Zyklus zur Lokalisierung der Bruchstelle auslöst, wobei die einzelnen Module (20) gemäß ihrer Anschlußreihenfolge in der Leitung nacheinander abgefragt werden.
